Europäisches Patentamt

European Patent Office

Office européen des brevets

(11) Publication number: **0 495 990 A1**

## EUROPEAN PATENT APPLICATION
### published in accordance with Art. 158(3) EPC

(21) Application number: 91913665.5

(22) Date of filing: 05.08.91

(86) International application number:
**PCT/JP91/01044**

(87) International publication number:
**WO 92/02957 (20.02.92 92/05)**

(51) Int. Cl.5: **H01L 27/118, H01L 21/82**

(30) Priority: **10.08.90 JP 213207/90**

(43) Date of publication of application:
**29.07.92 Bulletin 92/31**

(84) Designated Contracting States:
**DE FR GB**

(71) Applicant: **SEIKO EPSON CORPORATION**
**4-1, Nishishinjuku 2-chome**
**Shinjuku-ku Tokyo 163(JP)**

(72) Inventor: **MIZUNO, Masao, 3-5, Owa 3-chome**
**Suwa-shi**
**Nagano-ken 392(JP)**

(74) Representative: **Blumbach Weser Bergen**
**Kramer Zwirner Hoffmann Patentanwälte**
**Radeckestrasse 43**
**W-8000 München 60(DE)**

(54) SEMICONDUCTOR DEVICE.

(57) A semiconductor device using plural CMOSs, e.g. using standard cells, each of which comprises two CMOSs. When each of functional cells constituting a circuit comprises an odd number of CMOSs, one of the CMOSs is left unused. By allowing plural functional cells to own a standard cell in common, it is possible to utilize the unused CMOS effectively and realize a large scale integrated semiconductor device capable of operating at a high speed. Further, the wirings parallel with the wiring of a power supply are formed using a first wiring layer, and the wirings orthogonal to it are formed using a second wiring layer. Thereby, the wirings are prevented from interfering with each other, and the semiconductor device is designed and configured easily.

FIG. 1

SECOND-LAYER WIRING

FIRST-LAYER WIRING

## TECHNICAL FIELD

The present invention relates to a semiconductor device which is made up of a series of basic cells each having a plurality of complementary MISFETs (insulated gate field effect transistors) and, in particular, to the arrangement and wiring of function cells constituting circuit components in a semiconductor device which is produced by the master slice method and which allows the formation of a CMOS-type large scale integrated circuit.

## BACKGROUND ART

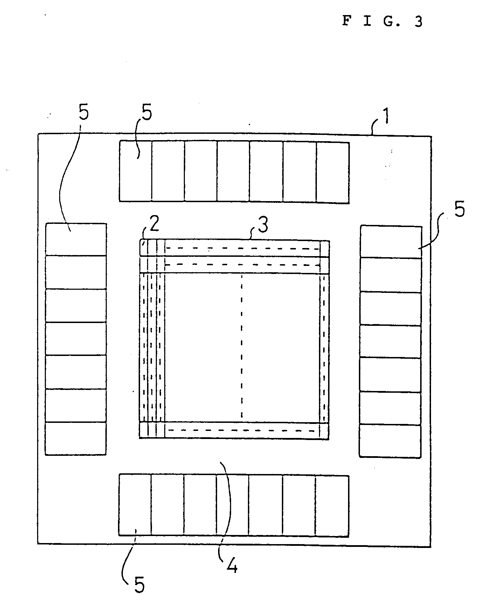

Fig. 3 shows the semiconductor device (the chip) of a complementary insulated gate field effect transistor (CMOS) produced by the master slice method generally in use. As shown in the drawing, the chip 1 has a substantially square configuration. Formed in the central portion of the chip is a function cell formation area 3, in which a plurality of basic cells 2 are arranged in the form of a matrix of rows and columns. Arranged around this function cell formation area 3 are a plurality of input/output cells 5 with an external wiring area 4 therebetween. The above-described construction using basic cells helps to prevent surface channel formation by arranging channel stopper layers between the basic cells. Further, it helps to restrain substrate potential difference through the channel stopper layers, thereby preventing latch-up. Thus, this construction provides a high level of reliability and is being widely used, for example, in a semiconductor device forming a circuit by the gate-array method.

Each of these basic cells 1 is formed of two CMOSs (complementary MOSs), each CMOS having one P-channel MOS and one N-channel MOS. Accordingly, a large number of CMOSs are formed in the function cell formation area 3. These CMOSs are connected to form function cells, which are formed into a circuit through internal wiring.

In designing such a circuit formed of a large number of CMOSs, CAD (Computer Aided Design) is employed for the arrangement of the function cells and for the wiring within and between cells. Fig. 4 shows an example of the layout and wiring of function cells used in conventional chips. As shown in Fig. 5, these function cells constitute inverters I1 and I2 and OR-NAND gates ON1 and ON2 used in flip-flops, etc. As shown in Fig. 6(a), each of these inverters I1 and I2 is composed of a pair of CMOSs 10a-10b. And, as shown in Fig. 6-(b), each of the OR-NAND gates ON1 and ON2 is composed of three pairs of CMOSs 11a-11b, 12a-12b and 13a-13b.

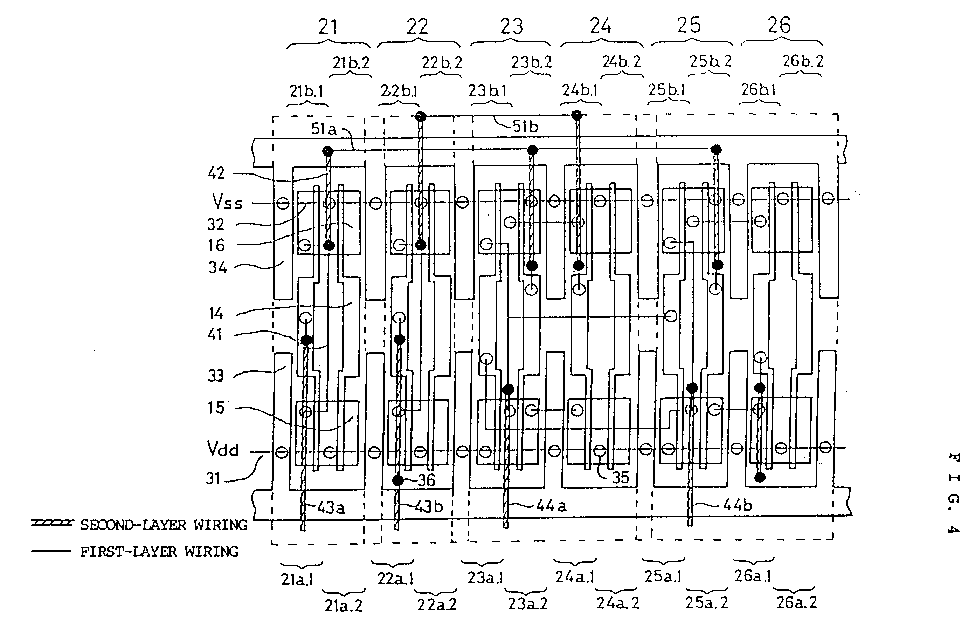

As shown in Fig. 4, when arranging these function cells in a conventional semiconductor device, six basic cells 21 through 26 are used. First, the inverter I1 consists of one of the two pairs of CMOSs in the basic cell 21, i.e., a P-channel MOS 21a.1 and an N-channel MOS 21b.1. Likewise, the inverter I2 consists of a P-channel MOS 22a.1 and an N-channel MOS 22b.1, of the basic cell 22. The OR-NAND gate ON1 comprises the two pairs of CMOSs of the basic cell 23, i.e., P-channel MOSs 23a.1 and 23a.2 and N-channel MOSs 23b.1 and 23b.2 and, further, one pair of CMOSs in the basic cell 24, i.e., a P-channel MOS 24a.1 and an N-channel MOS 24b.1. Likewise, the OR-NAND gate ON2 comprises the P-channel MOSs 25a.1 and 25a.2 and the N-channel MOSs 25b.1 and 25b.2, of the basic cell 25 and, further, one pair of CMOSs in the basic cell 26, i.e., a P-channel MOS 26a.1 and an N-channel MOS 26b.1.

Thus, in the basic cells 21 and 22 used in the inverters I1 and I2 of the above-described conventional semiconductor device, one pair each of CMOSs, i.e., (21a.2 and 21b.2) and (22a.2 and 22b.2) are left unused. Also, in the basic cells 24 and 26 used in the OR-NAND gates ON1 and ON2, one pair each of CMOSs, i.e., (24a.2 and 24b.2) and (26a.2 and 26b.2) are left unused. This is due to the fact that in the conventional semiconductor device design, the function cells are regarded as constructed by using basic cells as the units. That is, in designing the cell layout, the function cell allocation is determined on the basis of basic cells, which form the function cells. As a result, the basic cell construction is previously determined for each function cell, and those CMOSs which are not used at this stage will be left unused in the function cell layout, with the circuit being determined in this state. Thus, some CMOSs have to remain unused.

Such unused CMOSs are generated for each function cell when the number of pairs of CMOSs constituting the function cell is not an integral multiple of the number of pairs of CMOSs constituting the basic cell. However, the number of pairs of CMOSs constituting the function cell varies depending on the input/output amount and the function cell logic, so that it is impossible to standardize the number to a fixed integral multiple. Further, also with regard to the number of pairs of CMOSs forming the basic cell, a complicated wiring has to be involved when adjusting the function cell arrangement to the corresponding basic cell even in the case where the device is formed by using basic cells composed of different numbers of pairs of CMOSs, involving problems such as an excessive wiring length. Thus, the advantage of forming a device by using basic cells is lost. In view of this, conventional semiconductor devices are being designed and produced on the basis of an arrangement as described above, where basic cells are used as units, since it allows the arrangement and wiring of function cells to be effected efficiently and easily although it may involve some unused CMOSs.

However, in view of the recent demand for higher level of integration density and speed in semiconductor devices, the conventional design is being reconsidered in terms of cell arrangement and wiring, with the presence of unused CMOS constituting an important problem to be overcome. In a circuit formed by using a semiconductor device, the number of unused CMOSs due to inverters, etc. amounts to approximately 7% of the CMOSs existing on the device, and, when one takes into consideration the fact that the efficiency of use of the CMOSs existing in a semiconductor device as in the present state of the art is approximately 70%, it follows that the efficiency of use can be improved by approximately 10% through utilization of these unused CMOSs.

To focus on the wiring connecting the function cells to each other in a conventional semiconductor device, the wiring is provided, as shown in Fig. 4, in such a manner as to extend outside the unused CMOSs existing between adjacent function cells. For example, the output terminal of the inverter I1 is formed by an output wiring 41 connecting together the drain portion of the P-channel MOS 21a.1 and the drain portion of the N-channel MOS 21b.1 constituting the inverter I1. This output wiring 41 extends perpendicular to power wirings 31 and 32 to the exterior of the basic cell 21, where it is bent at right angles to extend parallel to the power wiring 32 up to the position of the N-channel MOS 23b.2 of the basic cell 23 forming the CMOSs 11a and 11b constituting the input terminal of the OR-NAND gate ON1. Then, it cuts the power wiring 32 at right angles again and extends inside the basic cell 23 to be connected to the gate portion of the MOS 23b.2. Further, where the power wiring 32 is cut at right angles, a wiring 42 is employed which is formed by using a second wiring layer that is formed on a first wiring layer through the intermediation of an insulating layer, thus avoiding interference with the power wiring 32.

Thus, the wiring in the above-described conventional semiconductor device first extends to the exterior of a basic cell and is connected to the input terminal of an adjacent function cell by way of an unused CMOS. In a semiconductor device which is to operate at high speeds, it is desirable that a large wiring length which may cause delay be avoided in every way. For this purpose, it is necessary to eliminate any unused CMOS which exists between function cells to be connected to each other and which has no influence on the circuit function, thereby reducing the distance between the adjacent cells.

Eliminating such unused CMOSs is effective from the viewpoint of semiconductor device function. As stated above, however, it is impossible to standardize the number of pairs of CMOSs forming the function cell to a fixed integral multiple of a value. On the other hand, it would be impractical to prepare basic cells having different numbers of pairs of component CMOSs. Thus, it has been difficult to attain an improvement in terms of integration level and speed by effectively utilizing unused CMOSs.

In view of the above problem, it is an object of the present invention to realize a highly integrated and high-speed semiconductor device which allows any unused CMOSs to be effectively utilized without affecting the numbers of pairs of CMOSs forming the basic and function cells.

DISCLOSURE OF THE INVENTION

In order to solve the above problem, the present invention adopts an arrangement in which the function cell construction is not limited to the one using basic cell as units, but one basic cell can be used for the construction of a plurality of function cells. In accordance with this invention, there is provided a semiconductor device of the type which has basic cells arranged in a matrix-like fashion each consisting of a plurality of complementary MISFETs, which are used to form function cells that are connected to form a predetermined circuit, the semiconductor device being characterized in that at least one of the basic cells is shared by a plurality of the above-mentioned function cells.

Thus, in arranging function cells, in particular, such function cells as cannot be formed by a number of complementary MISFETs corresponding to an integral multiple of the number of pairs of complementary MISFETs forming a basic cell, a layout is adopted which allows basic cells to be commonly shared, instead of a layout based on basic cells, whereby those complementary MISFETs in the basic cells which have been left unused in the prior art can be utilized in the construction of adjacent function cells. Thus, it is possible to effectively utilize the complementary MISFETs constituting the basic cells, thereby making it possible to attain an improvement in terms of semiconductor device integration level. Further, since adjacent function cells can be arranged in the same basic cell, the length of the wiring for connecting the function cells to each other can be reduced, thus making it possible to avoid delay and attain an increase in speed.

On account of the problems related to the power contact position, the processing of the intermediate drains of the plurality of pairs of complementary MISFETs constituting the basic cells, etc., a semiconductor device as described above, in which a basic cell is shared by a plurality of function cells, cannot be realized solely by displacing the function cells in parallel beyond the frame of the basic cells. In view of this, in accordance with this invention, there are provided, in a basic cell shared by a plurality of function cells, power contacts which are arranged in intermediate drains constituting a border between these function cells and connecting together the plurality of complementary MISFETs constituting the basic cell. Further, the above plurality of function cells are arranged in accordance with a layout selected from at least two inversion layouts which are symmetric with respect to these power contacts.

Generally, the connection of function cells is effected through wiring between the diffusion area of the complementary MISFETs serving as the output terminal and the gate portion serving as the input terminal. Therefore, there is little connection between diffusion areas, and, for a basic cell to be shared by a plurality of function cells, it is desirable that power contacts common to these function cells be arranged in the intermediate drains constituting the diffusion area connecting these function cells. And, it is necessary for each of the function cells sharing the basic cell to be able to be arranged both to the right and left with respect to these power contacts. To effect this, it is desirable that at least two inversion layouts be available, from which the the function cell layout is to be selected.

In a semiconductor device generally in use which has basic cells each composed of two pairs of complementary MISFETs, at least part of the function cells, consisting of an odd number of pairs of complementary MISFETs, is characteristically formed such that one function cell shares one basic cell with an adjacent function cell consisting of complementary MISFETs. And, power contacts are arranged in the intermediate drains constituting the borders between the function cells consisting of an odd number of pairs of complementary MISFETs. Further, these function cells are effectively arranged in accordance with a layout selected from layouts which are at least symmetric with respect to the power contacts.

By thus arranging the function cells such that they share basic cells in common, the complementary MISFETs constituting the basic cells can be used more efficiently, thereby heightening the degree of integration of the semiconductor device. Further, to focus on the arrangement of the wiring for connecting these complementary MISFETs and that for connecting the function cells, the conventional wiring is arranged around the basic cells in order to avoid a wiring which connects the output terminals of complementary MISFETs to each other or one which connects to the gate portions of complementary MISFETs. That is, in the prior-art arrangement, the wiring for connecting the function cells extends from the source portion of a complementary MISFETs to the exterior of the basic cell in such a manner as to cross a power wiring at right angles; then, it extends parallel to the power wiring up to the position of an adjacent function cell, to which it is connected after crossing the power wiring at right angles again. Thus, the exterior of each basic cell has been used as a wiring area, making it necessary to secure sufficient spaces between the basic cells, arranged in the longitudinal direction with these wiring areas therebetween.

To solve this problem, the present invention adopts an arrangement in which the output wiring for connecting the output terminals of the complementary MISFETs, which has been the cause of the wiring between the function cells or between the complementary MISFETs being formed by using the exterior of the basic cells, is formed by mainly using a second wiring layer which is deposited, through the intermediation of an insulating layer, on a first wiring layer that is formed on the surface of the semiconductor device. Accordingly, it is possible to effect connection between complementary MISFETs and between function cells by using an area in a basic cell where it has been difficult to set a wiring for the connection between complementary MISFETs. As a result, it is possible to reduce the wiring area which has been needed in the exterior of the basic cells, whereby a further improvement can be attained in terms of the degree of integration of a semiconductor device. At the same time, since connection can be effected between the function cells or between the complementary MISFETs in the basic cells, the wiring length can be substantially reduced, with the result that a reduction in delay due to wiring can be attained, thus making it possible to realize a high-speed device. Further, it is also possible to avoid interference between the power wiring and the inter-cell wiring.

With this wiring method, not only the output wirings but also those wirings which cross the power wirings at right angles, such as the wirings connected to the gate portions of the complementary MISFETs, can be effectively formed by mainly using the second wiring layer. By thus forming wirings by using different wiring layers according to the wiring directions, interference between wirings can be reduced, thus making it possible to reduce the requisite time for layout design.

BRIEF DESCRIPTION OF THE DRAWINGS

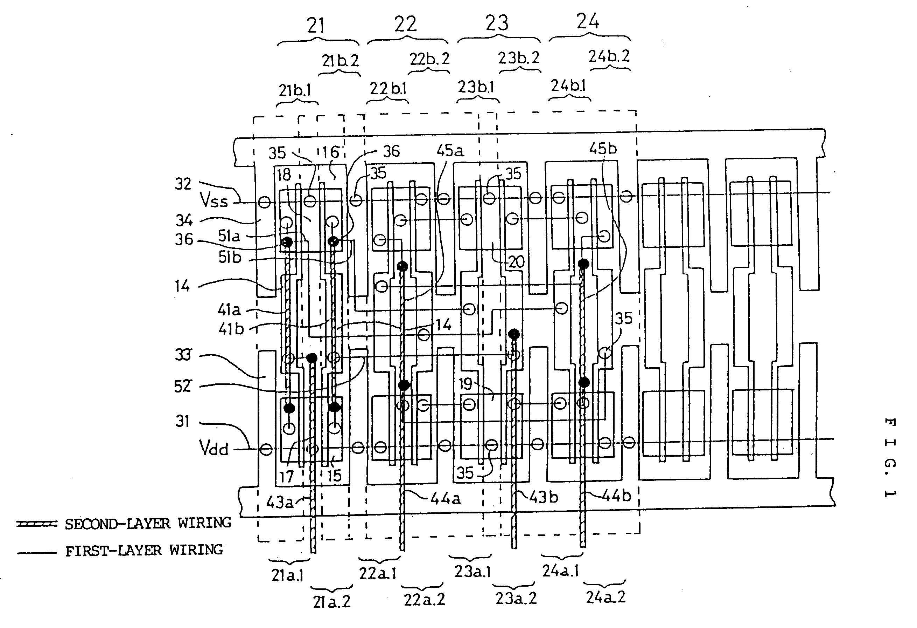

Fig. 1 is a plan view showing the function cell arrangement of a semiconductor device in accordance with an embodiment of the present invention;

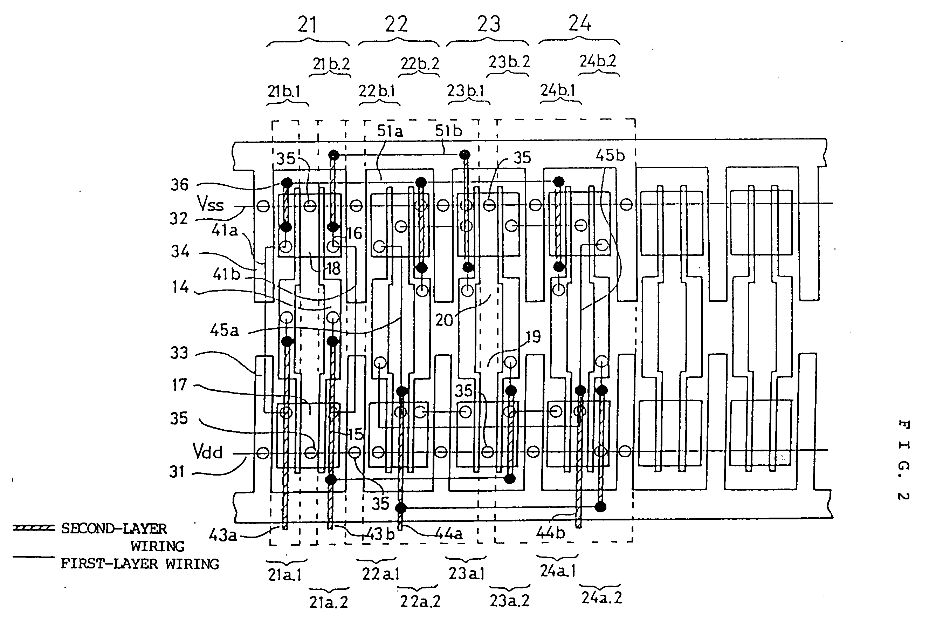

Fig. 2 is a plan view showing a function cell arrangement using a conventional wiring method in contrast with the present invention;

Fig. 3. is a diagram schematically illustrating a semiconductor device in accordance with an embodiment of this invention;

Fig. 4 is a plan view showing the function cell arrangement in a conventional semiconductor;

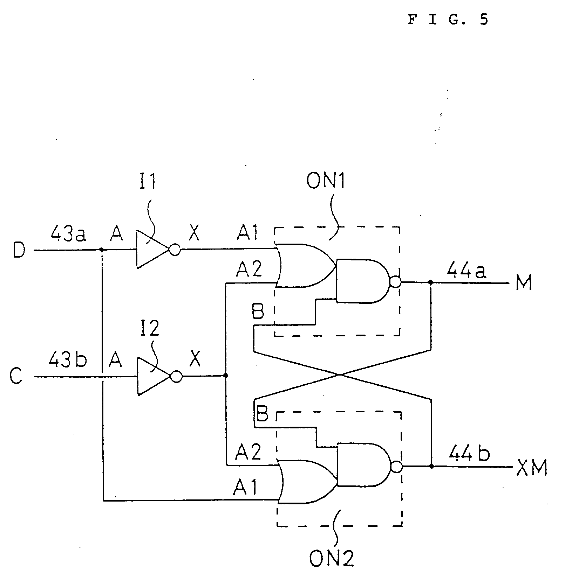

Fig. 5 is a logic circuit diagram showing function cells as used in the embodiment of this invention and in the conventional example; and

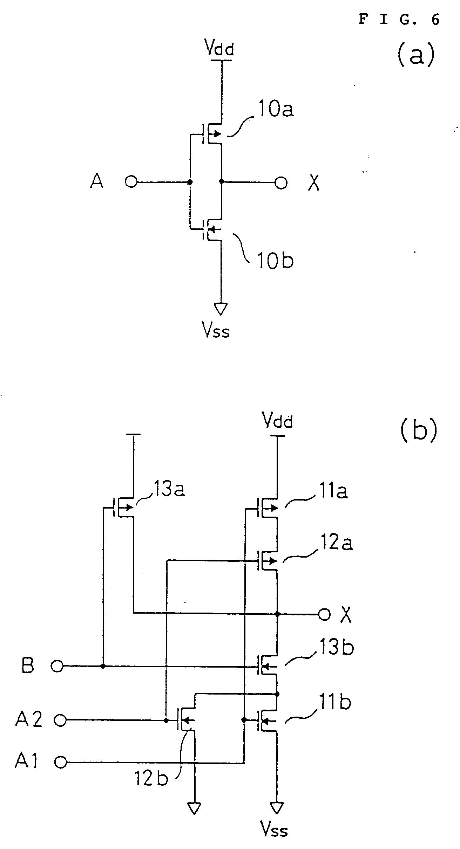

Fig. 6 is a diagram illustrating the transistor constructions of the logic gates shown in Fig. 5.

## BEST MODE FOR CARRYING OUT THE INVENTION

A best mode for carrying out the invention will now be described with reference to the accompanying drawings.

Fig. 1 shows the cell arrangement of a semiconductor device in accordance with an embodiment of this invention. The function cells arranged in this semiconductor device are two inverters I1 and I2 and two OR-NAND gates ON1 and ON2, which are similar to those of the above-described conventional semiconductor. As in the conventional semiconductor device, these function cells are connected to each other in the manner shown in Fig. 5, and the transistor construction of each function cell is shown in Fig. 6. Further, like the conventional example, the semiconductor device of this embodiment has basic cells each of which is composed of two pairs of CMOSs and which are arranged in a matrix-like manner. These CMOSs are connected together by wiring to form a circuit. What is to be noted in the device of this embodiment is that the above four function cells, which have been formed by using six basic cells in the conventional device, are formed by using four basic cells 21 through 24.

The basic cell 21 used in this device is composed of a P-type diffusion layer 15, an N-type diffusion layer 16 opposed to this diffusion layer 15, an N-type high-density stopper layer 33 arranged in the outer periphery of the P-type diffusion layer 15 in such a manner as to separate the basic cell from the adjacent one, and a P-type high-density stopper layer 34 arranged in the outer periphery of the N-type diffusion layer 16 in such a manner as to separate the basic cell from the adjacent one. And, two polysilicon areas spanning the P-type diffusion layer 15 and the N-type diffusion layer 16 are formed as gate electrodes 14, and, by these gate electrodes 14, two pairs of CMOSs are formed, one consisting of a P-channel MOS 21a.1 and an N-channel MOS 21b.1 and the other consisting of a P-channel MOS 21a.2 and an N-channel MOS 21b.2. The P-type diffusion layer connecting the P-channel MOSs 21a.1 and 21a.2 with each other constitutes a P-type intermediate drain 17, and N-type diffusion layer connecting the N-channel MOSs 21b.1 and 21b.2 with each other constitutes an N-type intermediate drain 18.

The function cells are formed by using these basic cells, each constructed as described above. First, the inverter I1 is composed of the P-channel MOS 21a.1 and the N-channel MOS 21b.1, which constitute one pair of CMOSs of the basic cell 21. And, the inverter I2 is composed of the P-channel MOS 21a.2 and the N-channel MOS 21b.2, which constitute the other pair of CMOSs of the same basic cell 21. The OR-NAND gate ON1 is composed of the two pairs of CMOSs of the basic cell 22, i.e., the P-channel MOSs 22a.1 and 22a.2 and the N-channel MOSs 22b.1 and 22b.2, and one pair of CMOSs of the basic cell 23, i.e., the P-channel MOS 23a.1 and the N-channel MOS 23b.1. And, the OR-NAND gate ON2 is composed of the other pair of CMOSs of the basic cell 23, i.e., the P-channel MOS 23a.2 and the N-channel MOS 23b.2 and the two pairs of CMOSs of the basic cell 24, i.e., the P-channel MOSs 24a.1 and 24a.2 the N-channel MOSs 24b.1 and 24b.2.

To focus on the basic cell 21, which is shared by the inverters I1 and I2, a contact 35 for connection with the power wiring 32 is formed in the intermediate drain 18 connecting the N-channel MOS 21b.1 constituting the inverter I1 with the MOS 21b.2 constituting the inverter I2. This is the same with the P-channel side. That is, a contact 35 for connection with the power wiring 31 is formed in the intermediate drain 17 connecting the MOS 21a.1 constituting the inverter I1 with the MOS 21a.2 constituting the inverter I2. The inverters I1 and I2 are arranged symmetrical with respect to these contacts 35.

The wirings for these inverters I1 and I2 are arranged as follows: First, an output wiring 41a which connects together the output terminals of the MOS 21b.1 and the MOS 21a.1 of the inverter I1, which crosses the power wirings 31 and 32 at right angles, is formed by using a second wiring layer, and, an output wiring 41b which connects together the output terminals of the MOS 21b.2 and the MOS 21a.2 of the inverter I2, is also formed by using the second wiring layer. And, these output wirings 41a and 41b are respectively connected through vias 36 to wirings 51a and 51b which extend parallel to the power wirings 31 and 32 toward the OR-NAND gates ON1 and ON2, through that area inside the basic cell which is between the power wirings 31 and 32. Like the power wirings 31 and 32, these wirings 51a and 51b are formed by using the second wiring layer. Thus, the wirings formed by using the second wiring layer are connected to the wirings of the first wiring layer through the vias 36. And, the wirings formed by using the first wiring layer are connected to the different positions of the basic cell through the contacts 35 in accordance with the circuit design.

Further, an input wiring 43a which is connected to the gate portion of the inverter I1 also crosses the power wiring 31 at right angles, and this wiring 43a is also formed by using the second wiring layer. Since the same input as that for the OR-NAND gate ON2 is applied to the gate portion of the inverter I2, a wiring 52 arranged parallel to the OR-NAND gate ON2 and the power wiring 31 is connected thereto. This wiring 52 is arranged in the inter-basic-cell section which is between the power wirings 31 and 32, and is formed, like the power wirings 31 and 32, by using the first wiring layer.

In the basic cell 23, which is shared by the OR-NAND gates ON1 and ON2, contacts are formed in its intermediate drains. That is, a contact 35 for connection with the power wiring 32 for supplying Vss is formed in an intermediate drain 20 connecting the N-channel MOSs 23b.1 and 23b.2 with each other, and a contact 35 for connection with the power wiring 31 for supplying Vdd is formed in an intermediate drain 19 connecting the P-channel MOSs 23a.1 and 23a.2 with each other. And, the OR-NAND gates ON1 and ON2 are arranged in a inversion layout symmetric with respect to these contacts 35. First, CMOSs 11a-11b constituting the OR-NAND gates ON1 and ON2 are formed by the MOSs 23a.1 and 23b.1 and the MOSs 23a.2 and 23b.2 forming the CMOS on either side of the contacts 35. By using the MOSs situated outside these MOSs, i.e., the MOSs 22a.2 and 22b.2 and the MOSs 24a.1 and 24b.1, CMOSs 12a-12b constituting the OR-NAND gates ON1 and ON2 are formed. Further, by using the MOSs situated outside these MOSs, i.e., the MOSs 22a.1 and 22b.1 and the MOSs 24a.2 and 24b.2, CMOSs 13a-13b constituting the OR-NAND gates ON1 and ON2 are formed. In this way, the OR-NAND gates ON1 and ON2 are arranged symmetric with respect to the contacts 35 formed in the intermediate drains of the basic cell 23.

To focus on the wiring used for the connection of these OR-NAND gates ON1 and ON2, the output sides of the MOSs 22a.1 and 22b.1, constituting the output terminals of the CMOSs 13a-13b, are connected to each other by the output wiring 45a formed by using the second wiring layer. And, the output sides of the MOSs 24a.2 and 24b.2 on the other end are also connected to each other by the output wiring 45b formed by using the second wiring layer, in such a manner as to cross the power wirings 31 and 32 at right angles. Further, the input wiring 43b connected to the gate of the CMOSs 11a-11b of the OR-NAND gate ON2 is also formed by using the second wiring layer in such a manner as to cross the power wiring 31 at right angles.

Thus, in the inverters I1 and I2 and the OR-NAND gates ON1 and ON2, all the wirings crossing the power wirings 31 and 32 at right angles are formed by using the second wiring layer. Accordingly, the wirings connecting the CMOSs to each other are formed by using the first wiring layer inside the basic cell section which is between the power wirings 31 and 32. Therefore, no wiring exists outside the basic cells which runs parallel to the power wirings 31 and 32, so that there is no need to secure a wiring area in the outer periphery of the basic cells. Furthermore, since the wirings connecting the CMOSs can be provided by substantially the shortest route, it is possible to reduce the wiring length. In addition, because of the established basic rule of forming those wirings running parallel to the power wirings by using the first wiring layer and forming those wirings crossing the power wirings at right angles by using the second wiring layer, little interference is involved between wirings, thus making it possible to reduce the time for wiring design.

Further, the power wirings 31 and 32 are also equipped with contacts 35 for connection with the channel stopper layers 33 and 34 arranged in such a manner as to form borders between the basic cells 21 through 24, thereby preventing channel formation due to semiconductor surface inversion between basic cells. Further, the difference between substrate potential and power potential is reduced through the stopper layers 33 and 34, thereby preventing latch-up of the parasitic transistors formed in the MOSs.

As described above, by arranging the two inverters I1 and I2 in one basic cell 21 and by allowing the basic cell 23 to be shared by the two OR-NAND gates ON1 and ON2, a cell layout which required six basic cells in the prior-art device can be realized with four basic cells, i.e., the number of basic cells can be reduced to 2/3 as compared with that of the prior-art device. Such a cell layout can be realized by using power contacts set in the intermediate drains constituting inter-function-cell borders and by adopting an inversion layout symmetric with respect to these contacts. Accordingly, those CMOSs which were left unused in the conventional device can be utilized effectively. Thus, the device of this embodiment helps to attain an improvement in integration degree.

It is possible, on the other hand, to adopt, in a device as described above where a basic cell is shared in common, the same wiring method as in the prior art. Even with such a device, it is possible to realize a semiconductor device with a higher degree of integration as shown in Fig. 2. In Fig. 2, the function cell construction is the same as that of Fig. 1, with the wiring being effected substantially the same way as in the conventional device described above. The same or equivalent components are referred to by the same reference numerals and a detailed description of this device will be omitted here.

However, to perform efficient wiring design for a device exhibiting a higher degree of integration and adopting a symmetric arrangement, it is desirable that a wiring method be adopted which is different from the conventional ones and which makes it possible to clearly recognize the wiring layers and avoid interference with ease.

Further, to efficiently utilize the CMOS which have been left unused in the prior art and to make the most of the effect of reducing the spaces between the adjacent function cells, it is desirable that the length of the wiring extending to the exterior of the basic cells be reduced. As a means for achieving this, it is possible, as described above, to adopt the wiring rule of forming those wirings crossing the power wirings at right angles by using the second wiring layer and forming those running parallel to the power wirings by using the first wiring layer. By adopting this wiring rule, the requisite time for wiring design can be shortened and, at the same time, a reduction in wiring length can be attained. Thus, combined with the reduction in inter-function-cell space effected by the elimination of the unused MOSs, this makes it possible to realize a semiconductor device of a higher operating speed. Further, that area which had to be secured for the wiring outside the basic cells in the prior-art device can be reduced, so that a further improvement can be attained in terms of degree of integration.

Further, while in this embodiment the arrangement is made in the order of the inverter I1, the inverter I2, the OR-NAND gate ON1, and the OR-NAND gate ON2, this order can be changed arbitrarily. For example, an arrangement in the order of an inverter, an OR-NAND gate, an inverter, and an OR-NAND gate, from left to right, can also be realized without involving any unused CMOSs by repeating the arrangement of the inverter I1 and that of the OR-NAND gate ON2, described above. That is, in a basic cell shared by an inverter and an OR-NAND gate, power contacts may be arranged in the intermediate drains constituting the border between the inverter and the OR-NAND gate; the inverter is formed on the left-hand side with respect to these contacts in the same arrangement as the inverter I1, and the OR-NAND gate on the right-hand side in the same arrangement as the OR-NAND gate ON2.

Of course, it is also possible to adopt an arrangement in the order of an OR-NAND gate, an inverter, an OR-NAND gate, and an inverter. In that case, the OR-NAND gate ON1 is arranged on the left-hand side with respect to the above-described power contacts formed in the intermediate drain, and, the inverter I2, arranged on the right-hand side with respect to the power contacts, is situated adjacent to the OR-NAND gate ON1. Subsequently, the inverter I1, situated on the left-hand side with respect to the power contacts may be arranged and, further, the OR-NAND gate ON2 situated on the right-hand side with respect to the power contacts.

Thus, even in an case where the number of pairs of CMOSs forming the function cells is not an integral multiple of the number pairs of CMOSs forming the basic cell, the generation of unused CMOSs can be prevented by setting power contacts in the intermediated drains of the basic cell and selecting a cell layout symmetric with respect to these power contacts. The types of function cells to which this arrangement is applicable is not limited to inverters and OR-NAND gates. In the case of a semiconductor device where each basic cell is composed of two pairs of CMOSs, the above arrangement is naturally applicable to function cells composed of an odd number of pairs of CMOSs, such as 3-input NAND gates and 5-input NAND gates.

Further, it is also possible to arrange in succession a function cell formed by a number of pairs of CMOSs which is not an integral multiple of the number of pairs of CMOSs forming a basic cell and one formed by a number of pairs of CMOSs which is an integral multiple of the number of pairs of CMOSs forming the basic cell. Also, in that case, power contacts are arranged in the intermediate drains constituting a border between the function cells, with the function cells being arranged in accordance with a cell layout selected from several inversion layouts.

INDUSTRIAL APPLICABILITY

Thus, with the semiconductor device of the present invention, which is characterized in that one basic cell is shared by a plurality of function cells as described above, it is possible to attain an improvement in terms of degree of device integration and, further, to prevent delay and attain a reduction in operating time. Accordingly, it is possible to realize, for example, a small, high-speed input/output device exhibiting a high level of integration.

**Claims**

1. In a semiconductor device of the type which has basic cells which are arranged in a matrix-like fashion and each of which consists of a plurality of complementary MISFETs, which are connected together to form function cells, a plurality of said function cells being connected together to form a predetermined circuit, the improvement comprising an arrangement in which at least one of said basic cells is a common cell shared by a plurality of said function cells.

2. A semiconductor device as claimed in Claim 1, wherein said common cells constitute borders between said plurality of function cells and wherein power contacts are provided in intermediate drains connecting said plurality of complementary MISFETs constituting said common cells, said plurality of function cells being arranged in accordance with a layout selected from at least two inversion layouts in which said function cells are arranged symmetric with respect to these power contacts.

3. A semiconductor device as claimed in one of Claims 1 and 2, wherein said plurality of function cells are formed by a number of complementary MISFETs which is not an integral multiple of the number of pairs of MISFETs constituting said basic cell.

4. A semiconductor device as claimed in Claim 3, wherein each of said basic cells is composed of two pairs of said complementary MISFETs, said plurality of function cells being composed of an odd number of pairs of complementary MISFETS.

5. In a semiconductor device of the type which has basic cells which are arranged in a matrix-like fashion and each of which consists of a plurality of complementary MISFETs, which are connected together to form function cells, a plurality of said function cells being connected together to form a predetermined circuit, the improvement comprising an arrangement in which output wirings connecting the output terminals of said complementary MISFETs to each other are formed by mainly using a second wiring layer deposited, through the intermediation of an insulating layer, on a first wiring layer formed on the surface of said semiconductor device.

6. A semiconductor device as claimed in one of Claims 1 and 4, wherein output wirings connecting the output terminals of said complementary MISFETs to each other are formed by mainly using a second wiring layer deposited, through the intermediation of an insulating layer, on a first wiring layer formed on the surface of said semiconductor device.

7. A semiconductor device as claimed in one of Claims 1 and 5, wherein the wiring connection between said complementary MISFETs and the wiring connection between said function cells are effected such that parallel wirings which are parallel to the power wirings of said complementary MISFETs are formed by mainly using said first wiring layer and that orthogonal wirings crossing said power wirings at right angles are formed by mainly using said second wiring layer.

F I G. 1

F I G. 2

SECOND-LAYER WIRING

FIRST-LAYER WIRING

F I G. 3

FIG. 4

EP 0 495 990 A1

F I G. 5

F I G. 6

(a)

Vdd

10a

A ○ ── ○ X

10b

Vss

(b)

Vdd

13a 11a

12a

○ X

B ○ 13b

A2 ○ 11b

A1 ○

12b

Vss

# INTERNATIONAL SEARCH REPORT

International Application No PCT/JP91/01044

| I. CLASSIFICATION OF SUBJECT MATTER (If several classification symbols apply, indicate all) * |
|---|
| According to International Patent Classification (IPC) or to both National Classification and IPC |
| Int. Cl$^5$  H01L27/118, H01L21/82 |

## II. FIELDS SEARCHED

| Minimum Documentation Searched [7] | |
|---|---|
| Classification System | Classification Symbols |
| IPC | H01L27/118, H01L21/82 |

| Documentation Searched other than Minimum Documentation to the Extent that such Documents are Included in the Fields Searched [8] |
|---|
| Jitsuyo Shinan Koho           1970 - 1991<br>Kokai Jitsuyo Shinan Koho      1971 - 1991 |

## III. DOCUMENTS CONSIDERED TO BE RELEVANT [9]

| Category * | Citation of Document, [11] with indication, where appropriate, of the relevant passages [12] | Relevant to Claim No. [13] |
|---|---|---|
| X,Y | JP, A, 57-133712 (Fujitsu Ltd.),<br>August 18, 1982 (18. 08. 82),<br>& EP, B1, 58504 & US, A, 4516312<br>& IE, B, 53196 | 1-4, 6-7 |
| X,Y | JP, A, 60-261155 (Fujitsu Ltd.),<br>December 24, 1985 (24. 12. 85),<br>Page 1, Fig. 1, (Family: none) | 5, 6-7 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| October 22, 1991 (22. 10. 91) | November 11, 1991 (11. 11. 91) |
| International Searching Authority | Signature of Authorized Officer |
| Japanese Patent Office | |

Form PCT/ISA/210 (second sheet) (January 1985)